(19) **Europäisches Patentamt / European Patent Office / Office européen des brevets**

(11) **EP 4 700 398 A1**

(12) **EUROPEAN PATENT APPLICATION**
published in accordance with Art. 153(4) EPC

(43) Date of publication:
25.02.2026 Bulletin 2026/09

(21) Application number: 24806652.4

(22) Date of filing: 17.05.2024

(51) International Patent Classification (IPC):
$G01R\ 31/00^{(2006.01)}$    $G01R\ 23/02^{(2006.01)}$
$G01R\ 25/00^{(2006.01)}$

(52) Cooperative Patent Classification (CPC):
Y02E 10/56

(86) International application number:
PCT/CN2024/093843

(87) International publication number:
WO 2024/235302 (21.11.2024 Gazette 2024/47)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 18.05.2023 CN 202310568828

(71) Applicant: EcoFlow Inc.
Shenzhen, Guangdong 518000 (CN)

(72) Inventors:
• HU, Xiong
  Shenzhen, Guangdong 518000 (CN)
• ZHAO, Mi
  Shenzhen, Guangdong 518000 (CN)
• CHEN, Xi
  Shenzhen, Guangdong 518000 (CN)
• WANG, Lei
  Shenzhen, Guangdong 518000 (CN)

(74) Representative: Appelt, Christian W.
Boehmert & Boehmert
Anwaltspartnerschaft mbB
Pettenkoferstrasse 22
80336 München (DE)

(54) **ISLANDING DETECTION METHOD AND DEVICE, GRID-TIE INVERTER AND COMPUTER-READABLE STORAGE MEDIUM**

(57) An islanding detection method includes: continuously detecting a voltage frequency at a point of common coupling; calculating, according to the voltage frequency, a frequency deviation of the voltage frequency between two adjacent detections; obtaining, when the frequency deviation is less than a preset frequency threshold, a voltage phase in a preset closed-loop phase-locking manner; obtaining, when the frequency deviation is greater than or equal to the preset frequency threshold, the voltage phase in a preset open-loop phase-locking manner; determining, according to the frequency deviation, the voltage frequency, and the voltage phase, a reference current for injecting a frequency perturbation; controlling, according to the reference current, the grid-connected inverter to output a current to the point of common coupling; and determining, when the voltage frequency exceeds a preset range, that an islanding effect occurs.

FIG. 3

**Description**

**CROSS-REFERENCE TO RELATED APPLICATIONS**

This application claims priority to Chinese Patent Application No. 202310568828.6, entitled "ISLANDING DETECTION METHOD AND APPARATUS, GRID-CONNECTED INVERTER, AND COMPUTER-READABLE STORAGE MEDIUM" filed with China National Intellectual Property Administration on May 18, 2023, which is incorporated by reference in its entirety.

**TECHNICAL FIELD**

This application relates to the technical field of grid-connected power supply systems, and specifically, to an islanding detection method and apparatus, a grid-connected inverter, and a computer-readable storage medium.

**BACKGROUND**

The statement herein only provides background information related to this application and does not necessarily constitute the exemplary technologies.

A grid-connected power supply system, as a micro grid system, is connected to a conventional centralized grid through a point of common coupling (PCC) during the grid connection. The grid-connected power supply system generally includes a power supply device and a grid-connected inverter. The grid-connected inverter converts direct current outputted by the power supply device into alternating current, and then outputs the alternating current to the grid and a load. During the grid connection, the alternating current voltage outputted by the grid-connected inverter needs to be synchronous with the frequency and the phase of the grid voltage. When the grid undergoes an outage due to a fault, if the fault cannot be detected in time, some lines whose power supply from the grid has been stopped may remain live, that is, the "islanding effect" occurs. The occurrence of the islanding effect may lead to power supply safety issues. In the related art, islanding is typically detected by injecting a perturbation (such as a phase perturbation, a frequency perturbation, or a current perturbation) of a related electrical parameter to a point of common coupling, but excessively slow detection of islanding still affects power supply safety.

**SUMMARY**

According to various embodiments of this application, an islanding detection method and apparatus, a grid-connected inverter, and a computer-readable storage medium are provided.

A first aspect of the embodiments of this application provides an islanding detection method, applied to a controller of a grid-connected inverter. The method includes: continuously detecting a voltage frequency at a point of common coupling; calculating, according to the voltage frequency, a frequency deviation of the voltage frequency between two adjacent detections; obtaining, when the frequency deviation is less than a preset frequency threshold, a voltage phase in a preset closed-loop phase-locking manner; obtaining, when the frequency deviation is greater than or equal to the preset frequency threshold, the voltage phase in a preset open-loop phase-locking manner; determining, according to the frequency deviation, the voltage frequency, and the voltage phase, a reference current for injecting a frequency perturbation; controlling, according to the reference current, the grid-connected inverter to output a current to the point of common coupling; and determining, when the voltage frequency exceeds a preset range, that an islanding effect occurs.

A second aspect of the embodiments of this application provides an islanding detection apparatus. The islanding detection apparatus includes: a voltage frequency detection module, configured to continuously detect a voltage frequency at a point of common coupling; a frequency deviation calculation module, configured to calculate, according to the voltage frequency, a frequency deviation of the voltage frequency between two adjacent detections; a voltage phase obtaining module, configured to detect, when the frequency deviation is less than a preset frequency threshold, a voltage phase in a preset closed-loop phase-locking manner, and detect, when the frequency deviation is greater than or equal to the preset frequency threshold, the voltage phase in a preset open-loop phase-locking manner; a reference current obtaining module, configured to determine, according to the frequency deviation, the voltage frequency, and the voltage phase, a reference current for injecting a frequency perturbation; and an islanding effect determining module, configured to control, according to the reference current, the grid-connected inverter to output a current to the point of common coupling, and determine, when the voltage frequency exceeds a preset range, that an islanding effect occurs.

A third aspect of the embodiments of this application provides a grid-connected inverter, including a controller and an inverter circuit. The controller is configured to perform steps of the islanding detection method provided in the embodiments of this application.

A fourth aspect of the embodiments of this application provides a computer-readable storage medium, configured to store a computer program or code. The computer program or code, when executed by a processor, implements steps of the islanding detection method provided in the embodiments of this application.

Details of one or more embodiments of this application are provided in the following accompanying drawings and descriptions. Other features, objectives, and advantages of this application become apparent with reference to the specification, the accompanying drawings, and the claims.

## BRIEF DESCRIPTION OF THE DRAWINGS

To describe the technical solutions in embodiments or exemplary technologies of this application more clearly, the following briefly describes the accompanying drawings required for describing the embodiments or exemplary technologies. Apparently, the accompanying drawings in the following description show merely some embodiments of this application, and a person of ordinary skill in the art may still derive drawings of other embodiments from these accompanying drawings without creative efforts.

FIG. 1 is a schematic structural diagram of a grid-connected power supply system according to an example.
FIG. 2 is a schematic diagram of a frequency offset of a current according to an example.
FIG. 3 is a flowchart of an islanding detection method according to an embodiment of this application.
FIG. 4 is a schematic structural diagram of a three-phase SRF-PLL according to an example.
FIG. 5 is a flowchart of an islanding detection method according to another embodiment of this application.
FIG. 6 is a schematic structural diagram of an islanding detection apparatus according to an embodiment of this application.
FIG. 7 is a schematic structural diagram of a grid-connected inverter according to an embodiment of this application.

## DETAILED DESCRIPTION

It should be noted that in the specification, claims, and accompanying drawings of this application, the terms "first" and "second" are used to distinguish similar objects rather than describe a specific order.

In addition, it should be noted that, the method disclosed in the embodiments of this application or the method shown in the flowcharts includes one or more steps for implementing the method. The steps may be interchanged with each other, and some steps may also be deleted without departing from the scope of the claims.

The following describes some embodiments with reference to the accompanying drawings. In a case of no conflict, the following embodiments and features of the embodiments may be combined with each other.

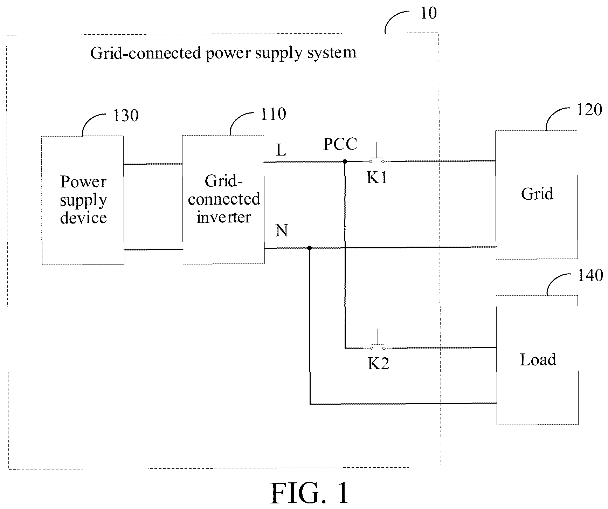

FIG. 1 is a schematic structural diagram of a grid-connected power supply system according to an example.

As shown in FIG. 1, the grid-connected power supply system 10 includes a grid-connected inverter 110 and a power supply device 130. When connected to a grid 120, the grid-connected power supply system may obtain power from the grid 120 to supply power to an important load (not shown in FIG. 1) connected to the grid-connected power supply system 10, or to feed power to the grid 120 to supply power to a family load (for example, a load 140 in FIG. 1) together. The power supply device 130 is electrically connected to the grid-connected inverter 110, and the power supply device 130 is configured to input direct current to the grid-connected inverter 110. The grid-connected inverter 110 is electrically connected to the grid 120 and the load 140 through alternating current output ports (for example, a live L terminal and a neutral N terminal in FIG. 1). The grid-connected inverter 110 is configured to convert direct current outputted by the power supply device 130 into alternating current, and then input the alternating current to the grid 120 and the load 140.

During grid connection, the grid-connected inverter 110 is connected to the grid 120 through a point of common coupling (PCC). A first switch (K1) between the grid-connected inverter 110 and the grid 120 is closed, and/or a second switch (K2) between the grid-connected inverter 110 and the load 140 is closed. The alternating current outputted by the grid-connected inverter 110 generally needs to be synchronous with the frequency and the phase of a voltage on the grid 120. When the grid 120 undergoes an outage due to a fault, K1 and K2 are closed. If the fault cannot be detected in time, some lines whose power supply from the grid 120 has been stopped may remain live (for example, the grid-connected inverter 110 continues to supply power to the load 140), that is, an "islanding effect" occurs. The occurrence of the islanding effect may lead to power supply safety issues. For example, when maintenance personnel are performing service, because K1, K2, and the load 140 remain live, an electric shock may occur at this time.

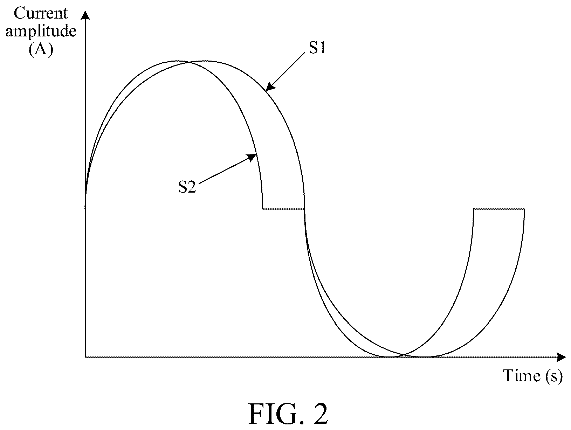

In the related art, islanding is typically detected by injecting a perturbation (such as a phase perturbation, a frequency perturbation, or a current perturbation) of a related electrical parameter to a point of common coupling (PCC). For example, the grid-connected inverter injects a reference current with a frequency perturbation to the PCC. As shown in FIG. 2, assuming that the current injected by the inverter to the grid is synchronous with the grid voltage, a standard waveform of the current is curve S1, a frequency of the current S1 is a voltage frequency of the grid, and a waveform of the reference current is curve S2. The frequency of the reference current has a frequency deviation relative to a voltage frequency of the grid. The frequency of the reference current is slightly greater than the voltage frequency of the grid. When the grid normally supplies power, the voltage frequency at the PCC is clamped to the voltage frequency of the grid by the alternating current provided by the grid, and the frequency perturbation of the reference current does not affect the voltage frequency at the PCC. On the contrary, when the grid undergoes an outage due to a fault, in this case, the voltage frequency at the PCC changes with the waveform of the reference current. After accumulation for a particular time, the frequency deviation exceeds a preset range, and therefore, the islanding effect is detected. However, excessively slow detection of islanding still affects power supply safety. For example, before the islanding effect is detected, if the voltage frequency at the PCC reaches a new balance and is consistent with the voltage frequency of the grid, the islanding effect cannot be detected.

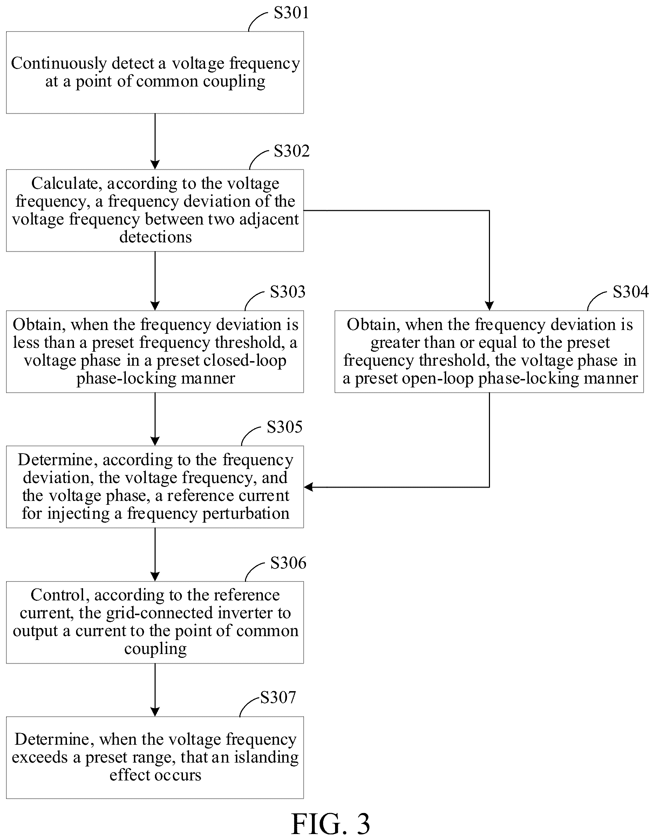

FIG. 3 is a flowchart of an islanding detection method according to an embodiment of this application. The islanding detection method is applied to a grid-connected inverter.

As shown in FIG. 3, the islanding detection method may include the following steps:

S301: Continuously detect a voltage frequency at a point of common coupling.

In this embodiment, a controller of the grid-connected inverter (hereinafter referred to as a controller) may detect the voltage frequency at the point of common coupling by using zero crossing interpolation. Specifically, the controller calculates the voltage frequency by detecting a duration of the voltage signal at the point of common coupling between two zero crossings.

It can be understood that the controller may continuously detect the voltage frequency at the point of common coupling according to a preset control period. The control period may be set as required.

S302: Calculate, according to the voltage frequency, a frequency deviation of the voltage frequency between two adjacent detections.

It can be understood that the frequency deviation refers to a frequency difference of the voltage frequency between two adjacent detections. After f1 and f2 are continuously detected twice, the controller calculates a difference between f1 and f2, to obtain a frequency deviation $\Delta f$. For example, if the voltage frequency detected last time is 52 Hz (Hertz) and the voltage frequency detected this time is 53 Hz, the frequency deviation is 1 Hz. For another example, if the voltage frequency detected last time is 51 Hz and the voltage frequency detected this time is 49 Hz, the frequency deviation is -2 Hz.

S303: Obtain, when the frequency deviation is less than a preset frequency threshold, a voltage phase in a preset closed-loop phase-locking manner.

The preset frequency threshold may be set as required. For example, the preset frequency threshold may be set to 3 Hz, 5 Hz, or the like.

It can be understood that, herein, the frequency deviation being less than the preset frequency threshold means that an absolute value of the frequency deviation is less than the preset frequency threshold.

In this embodiment, the closed-loop phase-locking manner is closed-loop phase locking based on negative feedback. In the closed-loop phase-locking manner, the frequency deviation may be adjusted according to the negative feedback amount, so that the voltage phase and frequency outputted by a phase-locked loop are synchronous with those of the grid, thereby implementing the tracking and locking of the voltage phase and frequency.

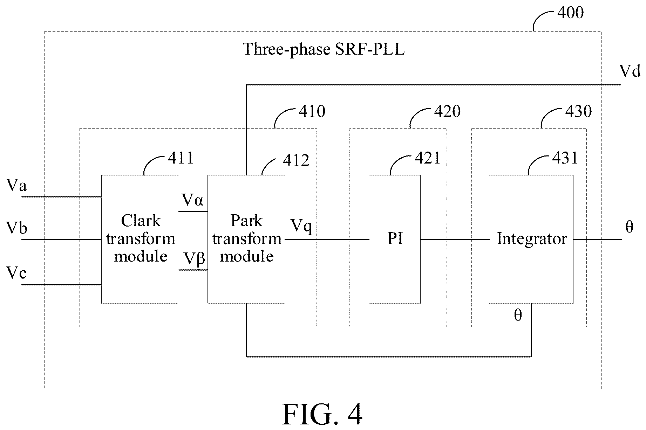

A synchronous reference frame phase-locked loop (SRF-PLL) is taken as an example. As shown in FIG. 4, a three-phase SRF-PLL 400 includes a phase detector (PD) 410, a loop filter (LF) 420, and a voltage controlled oscillator (VCO) 430. The working process of the three-phase SRF-PLL 400 includes: an output signal is fed back to an input terminal, and adjusted through the loop such that an angular frequency of the output signal is consistent with that of the input signal, and thereby a phase difference between the input signal and the output signal is constant, that is, the loop reaches a "locked" state, thereby achieving phase-locking of the input signal. When the three-phase SRF-PLL is applied to the grid-connected inverter, the input signal is a voltage signal at the point of common coupling. When the grid normally supplies power, the voltage signal is the grid voltage.

Still referring to FIG. 4, the PD 410 is configured to detect a phase difference between an input signal and an output signal and convert the detected phase difference into a voltage signal. The LF 420 is configured to filter out a high-frequency component in the voltage signal outputted by the PD 410. The VCO 430 is configured to adjust, according to a voltage signal outputted by the PD 410, a frequency and a phase of the output signal, and feed back the phase of the adjusted output signal to the PD 410, thereby completing closed-loop control based on the negative feedback.

For example, the PD 410 includes a Clark transform module 411 and a Park transform module 412. The Clark transform module 411 is configured to transform three-phase input signals Va, Vb, and Vc into a static $\alpha\beta$ coordinate system, to obtain two-phase output signals V$\alpha$ and V$\beta$. The Park transform module 412 is configured to transform, according to the detected phase difference, V$\alpha$ and V$\beta$ outputted by the Clark transform module 411 into a rotated dq coordinate system, to obtain output signals Vd and Vq. Vd is a voltage amplitude. When the phase-locked loop implements phase locking, that is, the phase difference between the output signal and the input signal is 0, Vq is 0, that is, a set value of Vq is 0.

The LF 420 includes a proportional-integral (PI) controller 421. The PI 421 is configured to perform, based on the set value 0, proportional and integral control on Vq outputted by the Park transform module 412.

The VCO 430 includes an integrator 431. The integrator 431 is configured to integrate an operation result outputted by the PI controller 421, to obtain a phase θ. The phase θ outputted by the integrator 431 is fed back to the Park transform module 412 as a negative feedback amount, and used to calculate a difference with the phase of the input signal, thereby implementing closed-loop control. When Vq is 0, it indicates that a rotation speed and a phase of the dq coordinate system are synchronous with those of the grid, and the corresponding phase θ is the voltage phase of the grid.

In one embodiment, the closed-loop phase-locking manner is Kalman phase locking. For a specific implementation process of Kalman phase locking, reference may be made to implementations in the related art, which is not described in detail in this application.

It can be understood that when the frequency deviation is relatively small, it indicates that there is no possibility of the occurrence of the islanding effect. In this case, the voltage phase is locked by means of closed-loop phase locking. Compared with open-loop phase locking, the voltage phase of the grid can be tracked quickly and precisely, thereby improving the phase locking precision.

S304: Obtain, when the frequency deviation is greater than or equal to the preset frequency threshold, the voltage phase in a preset open-loop phase-locking manner.

In this embodiment, the open-loop phase-locking manner is a phase-locking manner in which feedback control is not performed. When the frequency deviation is greater than or equal to the preset frequency threshold, it indicates that the islanding effect may occur. During islanding detection, because there is no negative feedback amount in the open-loop phase-locking manner, the perturbation with positive feedback injected during islanding detection will not be counterbalanced. Therefore, the frequency perturbation rapidly accumulates, thereby reducing the delay in detecting the islanding effect and improving the speed of detecting the islanding effect.

In one embodiment, the open-loop phase-locking manner is zero crossing phase locking. For a specific implementation process of the zero crossing phase locking, reference may be made to implementations in the related art, which is not described in detail in this application.

S305: Determine, according to the frequency deviation, the voltage frequency, and the voltage phase, a reference current for injecting a frequency perturbation.

In this embodiment, after the voltage phase is obtained in the closed-loop phase-locking manner or the open-loop phase-locking manner, the controller may calculate, based on the voltage phase, the frequency deviation, and the voltage frequency, a reference phase of the reference current, and determine, according to a preset current amplitude and the reference phase, the reference current.

In one embodiment, the controller may calculate the reference current according to formula (1):

$$I_{ref} = I * \sin \theta_k \qquad\qquad (1)$$

where $I_{ref}$ represents a reference current, $I$ represents a preset current amplitude, and $\theta_k$ represents a reference phase for injecting frequency perturbation. The reference phase $\theta_k$ is controlled between 0 and $2\pi$. When $\theta_k$ is greater than $2\pi$, a difference between $\theta_k$ and $2\pi$ is assigned to $\theta_k$. $\theta_k$ is determined according to the voltage phase, the frequency deviation, and the voltage frequency. The frequency perturbation is positively correlated with the frequency deviation.

In another embodiment, the controller may calculate the reference current according to formula (2):

$$I_{ref} = I * \cos \theta_k \qquad\qquad (2)$$

S306: Control, according to the reference current, the grid-connected inverter to output a current to the point of common coupling.

In this embodiment, after the reference current is determined, the controller may perturb the output current frequency of the grid-connected inverter by using the frequency perturbation carried in the reference current, thereby determining whether the islanding effect occurs by detecting whether the voltage frequency at the point of common coupling is within a preset range.

It can be understood that assuming that the grid fails to supply power due to a fault, the voltage frequency at the point of common coupling loses its clamping. When the islanding effect is detected by frequency perturbation, in an example in which the frequency deviation is a negative value, it indicates that the voltage frequency at the point of common coupling is decreasing at this time. Due to the presence of the phase-locked loop, the output current frequency of the grid-connected inverter will decrease. On such a basis, based on Ohm's law, the voltage frequency at the point of common coupling will further decrease as the output current frequency decreases, thereby implementing positive feedback perturbation until the voltage frequency exceeds the preset range.

S307: Determine, when the voltage frequency exceeds a preset range, that an islanding effect occurs.

It can be understood that when the voltage frequency at the point of common coupling is within the preset range, it indicates that perturbation of the voltage frequency is in a normal state. Therefore, it can be determined that the grid is in a normal power supply state, the voltage frequency at the point of common coupling can be clamped, and the frequency perturbation does not affect the voltage at the point of common coupling. When the voltage frequency exceeds the preset range, it indicates that the perturbation of the voltage frequency is abnormal. Therefore, it can be determined that the islanding effect occurs.

The preset range may be set as required. For example, assuming that a power frequency of a grid voltage is 50 Hz, the preset range may be set to greater than or equal to 48 Hz, and less than or equal to 52 Hz.

In the foregoing embodiment, when the frequency deviation is less than the preset frequency threshold, the voltage phase is detected in the preset closed-loop phase-locking manner, and the reference current with frequency perturbation is injected to the point of common coupling on such a basis. When the frequency deviation is greater than or equal to the preset frequency threshold, it indicates that an islanding effect may occur. Because the frequency perturbation that needs to be injected during islanding detection is a perturbation with positive feedback, if closed-loop phase locking based on negative feedback is used in this case, a negative feedback amount caused by the closed-loop phase locking may counterbalance the perturbation with positive feedback injected during islanding detection to some extent, and part of the frequency shift effect may be counterbalanced, causing a long delay in detecting the islanding effect or a failure to detect the islanding effect. Therefore, when the frequency deviation is greater than or equal to the preset frequency threshold, the voltage phase is detected in an open-loop phase-locking manner, and the reference current with frequency perturbation is determined on such a basis, so as to continue to inject the frequency perturbation to the point of common coupling and determine the occurrence of the islanding effect when the voltage frequency at the point of common coupling exceeds the preset range. Because there is no negative feedback in the open-loop phase locking, the perturbation with positive feedback injected during islanding detection is not counterbalanced. Therefore, when the grid undergoes an outage due to a fault, the frequency perturbation rapidly accumulates, so that the voltage frequency at the point of common coupling rapidly exceeds the preset range, thereby reducing the delay in detecting the islanding effect, and improving the speed of detecting the islanding effect.

In an embodiment, the islanding detection method further includes: determining, when the voltage frequency does not exceed the preset range, that the islanding effect does not occur.

It can be understood that because the voltage frequency at the point of common coupling does not exceed the preset range, it indicates that the grid is in a connected state and does not undergo an outage due to a fault, that is, the islanding effect does not occur.

In another embodiment, the determining, according to the frequency deviation, the voltage frequency, and the voltage phase, a reference current for injecting a frequency perturbation includes: determining, according to a preset gain coefficient and the frequency deviation, a frequency perturbation amount; calculating, according to the voltage phase, the voltage frequency, and the frequency perturbation amount, a reference phase of the reference current; and determining, according to a preset current amplitude and the reference phase, the reference current.

For example, the controller may calculate the reference phase according to formula (3):

$$\theta_k = \theta + 2\pi * (f + kp * \Delta f) * t \qquad\qquad (3)$$

where $\theta_k$ represents a reference phase, $\theta$ represents a voltage phase obtained in the closed-loop phase-locking manner or the open-loop phase-locking manner, $f$ represents a voltage frequency at the point of common coupling, $\Delta f$ represents a frequency deviation, $kp$ represents a gain coefficient, and $t$ represents time. ($kp * \Delta f$) is an injected frequency perturbation amount.

It can be understood that the gain coefficient is used to amplify the frequency deviation, thereby accelerating the accumulation of the frequency perturbation amount. The gain coefficient may be set as required. For example, the gain coefficient may be set to 2, 5, 10, or the like.

In the foregoing embodiment, because the reference phase of the reference current changes with the frequency perturbation amount, as the frequency perturbation amount increases, the reference phase of the reference current also increases. This causes an increase in the real-time phase of the output current, which in turn causes a further increase in the frequency perturbation amount, thereby implementing positive feedback perturbation. In this way, when the islanding effect occurs, the frequency perturbation can rapidly accumulate, which is beneficial to reducing the delay in detecting the islanding effect, and improving the speed of detecting the islanding effect.

In another embodiment, the islanding detection method further includes: disconnecting, when determining that the islanding effect occurs, the grid-connected inverter from a grid.

It can be understood that when determining that the islanding effect occurs, it indicates that the grid cannot normally supply power. In this case, the grid-connected inverter should be disconnected from the grid, so that this part of the circuit is not live, thereby ensuring safety. Using FIG. 1 as an example, in this case, K1 may be controlled to open, so that the grid-connected inverter is disconnected from the grid. In this case, the part of the circuit in the grid that is connected to the grid-connected inverter is no longer live, and can be serviced normally.

In another embodiment, the islanding detection method further includes: determining, when switching from the preset closed-loop phase-locking manner to the preset open-loop phase-locking manner, a first phase that is latest detected in the preset closed-loop phase-locking manner as a phase initial value of the preset open-loop phase-locking manner.

It can be understood that due to the accumulation of the frequency perturbation, the frequency deviation gradually increases. When the frequency deviation is greater than or equal to the preset frequency threshold, the controller controls the phase-locking manner to switch from the closed-loop phase-locking manner to the open-loop phase-locking manner. In this case, to ensure smooth switching of the phase-locking manner, the controller determines the first phase that is latest detected in the closed-loop phase-locking manner as the phase initial value of the open-loop phase-locking manner. This helps maintain the phase continuity during the switching of the phase-locking manner, and avoids the need to perform phase-locking tracking again after the switching of the phase-locking manner, which affects the stability of the output current of the grid-connected inverter.

In another embodiment, the islanding detection method further includes: determining, when switching from the preset open-loop phase-locking manner to the preset closed-loop phase-locking manner, a second phase that is latest detected in the preset open-loop phase-locking manner as a phase initial value of the preset closed-loop phase-locking manner.

It can be understood that, when the grid experiences a temporary fault and rapidly restores connection, during the fault of the grid, as the frequency perturbation accumulates, the frequency deviation gradually increases. When the frequency deviation is greater than or equal to the preset frequency threshold, the controller controls the phase-locking manner to switch from the closed-loop phase-locking manner to the open-loop phase-locking manner. After the connection of the grid is restored, as the frequency perturbation decreases, the frequency deviation gradually decreases. When the frequency deviation is less than the preset frequency threshold, the controller controls the phase-locking manner to switch from the open-loop phase-locking manner to the closed-loop phase-locking manner. In this case, to ensure smooth switching of the phase-locking manner, the controller determines the second phase that is latest detected in the open-loop phase-locking manner as the phase initial value of the closed-loop phase-locking manner. This helps maintain the phase continuity during the switching of the phase-locking manner, and avoids performing phase-locking tracking again after the switching of the phase-locking manner.

In another embodiment, the controlling, according to the reference current, the grid-connected inverter to output a current to the point of common coupling includes: obtaining a current output current of the grid-connected inverter; determining, according to the reference current, the current output current, and a preset inversion control algorithm, a drive signal; and controlling, by using the drive signal, the grid-connected inverter to output the current to the point of common coupling.

The inversion control algorithm may be a sinusoidal pulse width modulation (SPWM) manner. For example, the inversion control algorithm is an SPWM closed-loop control manner based on a current loop. For the implementation of the SPWM closed-loop control manner, reference may be made to the related art. For example, it may be implemented by using a PI controller, which is not described in detail in this application.

In the foregoing embodiment, after the reference current is obtained, the controller uses, based on the inversion control algorithm, the frequency perturbation of the reference current as a control target of the output current of the grid-connected inverter, to obtain the drive signal carrying the frequency perturbation information. Then, the grid-connected inverter is controlled by using the drive signal to output the current to the point of common coupling. Therefore, the output current of the grid-connected inverter carries the frequency perturbation. When the grid fails to supply power due to a fault, the frequency perturbation continuously accumulates. In this case, it can be determined whether the islanding effect occurs by detecting whether the voltage frequency at the point of common coupling is within the preset range.

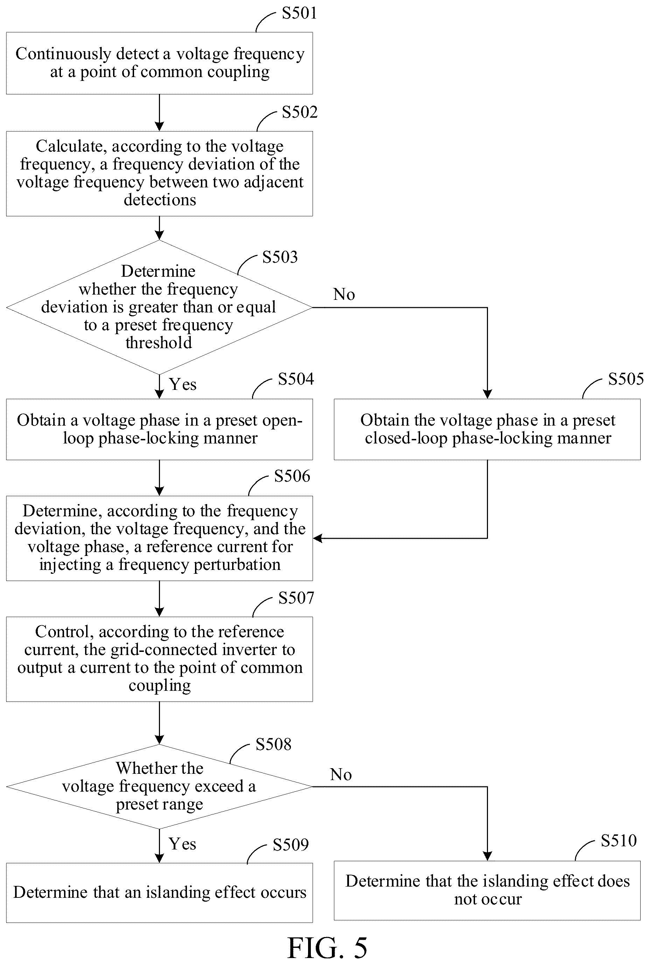

FIG. 5 is a flowchart of an islanding detection method according to another embodiment of this application. The islanding detection method is applied to a grid-connected inverter.

As shown in FIG. 5, the islanding detection method may include the following steps:

S501: Continuously detect a voltage frequency at a point of common coupling.
S502: Calculate, according to the voltage frequency, a frequency deviation of the voltage frequency between two adjacent detections.
S503: Determine whether the frequency deviation is greater than or equal to a preset frequency threshold.

If the frequency deviation is greater than or equal to the preset frequency threshold, step S504 and step S506 to step S508 are performed; and if not, step S505 and step S506 to step S508 are performed.

S504: Obtain a voltage phase in a preset open-loop phase-locking manner.

S505: obtain the voltage phase in a preset closed-loop phase-locking manner.

S506: Determine, according to the frequency deviation, the voltage frequency, and the voltage phase, a reference current for injecting a frequency perturbation.

S507: Control, according to the reference current, the grid-connected inverter to output a current to the point of common coupling.

S508: Determine whether the voltage frequency exceeds a preset range.

If the voltage frequency exceeds the preset range, step S509 is performed; and if not, step S510 is performed.

S509: Determine that an islanding effect occurs.

S510: Determine that the islanding effect does not occur.

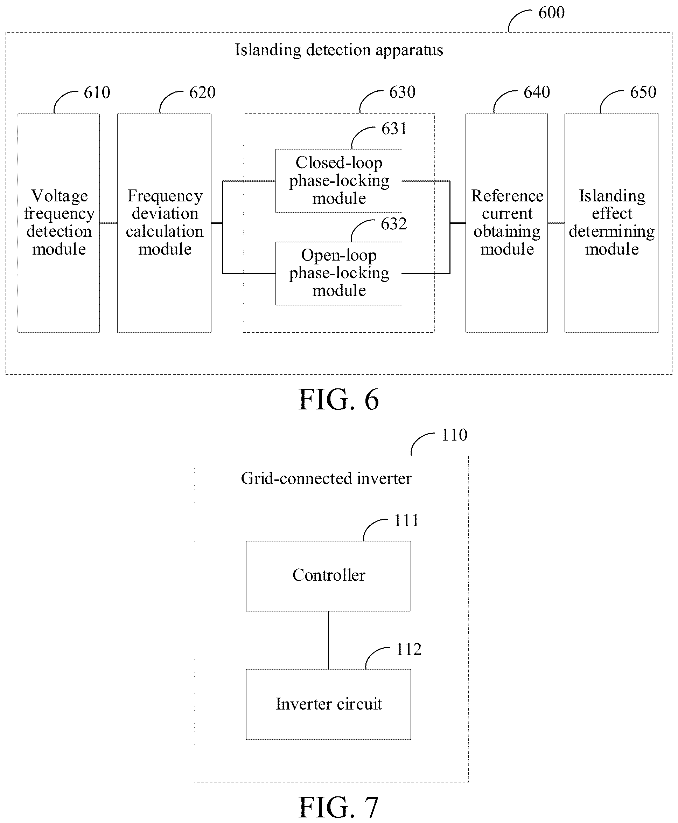

FIG. 6 is a schematic structural diagram of an islanding detection apparatus according to an embodiment of this application. The islanding detection apparatus may be an apparatus in the grid-connected inverter, or an apparatus electrically connected to the grid-connected inverter.

As shown in FIG. 6, the islanding detection apparatus 600 includes a voltage frequency detection module 610, a frequency deviation calculation module 620, a voltage phase obtaining module 630, a reference current obtaining module 640, and an islanding effect determining module 650.

The voltage frequency detection module 610 is configured to continuously detect a voltage frequency at a point of common coupling.

The frequency deviation calculation module 620 is configured to calculate, according to the voltage frequency, a frequency deviation of the voltage frequency between two adjacent detections.

The voltage phase obtaining module 630 is configured to detect, when the frequency deviation is less than a preset frequency threshold, a voltage phase in a preset closed-loop phase-locking manner, and detect, when the frequency deviation is greater than or equal to the preset frequency threshold, the voltage phase in a preset open-loop phase-locking manner. Specifically, the voltage phase obtaining module 630 includes a closed-loop phase-locking module 631 and an open-loop phase-locking module 632. The closed-loop phase-locking module 631 is configured to detect, when the frequency deviation is less than the preset frequency threshold, the voltage phase in the preset closed-loop phase-locking manner. The open-loop phase-locking module 632 is configured to detect, when the frequency deviation is greater than or equal to the preset frequency threshold, the voltage phase in the preset open-loop phase-locking manner;

The reference current obtaining module 640 is configured to determine, according to the frequency deviation, the voltage frequency, and the voltage phase, a reference current for injecting a frequency perturbation.

The islanding effect determining module 650 is configured to control, according to the reference current, the grid-connected inverter to output a current to the point of common coupling, and determine, when the voltage frequency exceeds a preset range, that an islanding effect occurs.

In an embodiment, the islanding effect determining module 650 is further configured to disconnect, when determining that the islanding effect occurs, the grid-connected inverter from a grid.

In another embodiment, the islanding effect determining module 650 is further configured to determine, when the voltage frequency does not exceed the preset range, that the islanding effect does not occur.

In another embodiment, the determining, by the reference current obtaining module 640 according to the frequency deviation, the voltage frequency, and the voltage phase, a reference current for injecting a frequency perturbation includes: determining, according to a preset gain coefficient and the frequency deviation, a frequency perturbation amount; calculating, according to the voltage phase, the voltage frequency, and the frequency perturbation amount, a reference phase of the reference current; and determining, according to a preset current amplitude and the reference phase, the reference current.

In another embodiment, the islanding detection apparatus 600 further includes a phase-locking manner switching module (not shown). The phase-locking manner switching module is configured to determine, when switching from the preset closed-loop phase-locking manner to the preset open-loop phase-locking manner, a first phase that is latest detected in the preset closed-loop phase-locking manner as a phase initial value of the preset open-loop phase-locking manner, and determine, when switching from the preset open-loop phase-locking manner to the preset closed-loop phase-locking manner, a second phase that is latest detected in the preset open-loop phase-locking manner as a phase initial value of the preset closed-loop phase-locking manner.

In another embodiment, the controlling, by the islanding effect determining module 650 according to the reference current, the grid-connected inverter to output a current to the point of common coupling includes: obtaining a current output current of the grid-connected inverter; determining, according to the reference current, the current output current, and a preset inversion control algorithm, a drive signal; and controlling, by using the drive signal, the grid-connected inverter to output the current to the point of common coupling.

It can be understood that the module division described above is logical function division and may be another division in actual implementation. In addition, function modules in the embodiments of this application may be integrated into a same processing unit, or each of the modules may exist alone physically, or two or more modules may be integrated into a same unit. The integrated module may be implemented in a form of hardware, or may be implemented a form of hardware and software function module.

FIG. 7 is a schematic structural diagram of a grid-connected inverter according to an embodiment of this application.

As shown in FIG. 7, the grid-connected inverter 110 includes a controller 111 and an inverter circuit 112. The controller 111 is configured to perform steps of the islanding detection method provided in the embodiments of this application. The inverter circuit 112 is configured to output, according to a signal or an instruction outputted by the controller 111, a current to a point of common coupling.

The controller 111 may be a central processing unit (CPU), or may be another general-purpose processor, a digital signal processor (DSP), an application-specific integrated circuit (ASIC), a field programmable gate array (FPGA) or another programmable logic device, a discrete gate or transistor logic device, a discrete hardware component, or the like. The general-purpose processor may be a microprocessor, any conventional processor, or the like.

It can be understood that the schematic structure of this embodiment does not constitute a specific limitation to the grid-connected inverter. In others embodiments, the grid-connected inverter may include more or fewer components than those shown in the figure, or some components may be combined, or some components may be split, or a different component deployment may be used.

An embodiment of this application further provides a computer-readable storage medium, configured to store a computer program or code. The computer program or code, when executed by a processor, implements steps of the islanding detection method provided in the embodiments of this application.

The computer-readable storage medium includes volatile and non-volatile media, and removable and non-removable media implemented in any method or technology used for storing information (such as a computer-readable instruction, a data structure, a program module, or other data). The computer-readable storage medium includes, but is not limited to, a random access memory (RAM), a read-only memory (ROM), an electrically erasable programmable read-only memory (EEPROM), a flash memory or another memory, a compact disc read-only memory (CD-ROM), a digital versatile disc (DVD) or another optical disc storage, a magnetic cassette, a magnetic tape, a magnetic disk storage or another magnetic storage apparatus, or any other medium that can be used to store expected information and can be accessed by a computer.

Finally, it should be noted that the foregoing embodiments are merely intended for describing the technical solutions of this application, but not for limiting this application. Although this application is described in detail with reference to preferred embodiments, persons of ordinary skill in the art should understand that modifications or equivalent replacements may be made to the technical solutions of this application without departing from the spirit and scope of the technical solutions of this application.

## Claims

1. An islanding detection method, applied to a grid-connected inverter, the method comprising:

   continuously detecting a voltage frequency at a point of common coupling;
   calculating, according to the voltage frequency, a frequency deviation of the voltage frequency between two adjacent detections;
   detecting, when the frequency deviation is less than a preset frequency threshold, a voltage phase in a preset closed-loop phase-locking manner;
   detecting, when the frequency deviation is greater than or equal to the preset frequency threshold, the voltage phase in a preset open-loop phase-locking manner;
   determining, according to the frequency deviation, the voltage frequency, and the voltage phase, a reference current for injecting a frequency perturbation;
   controlling, according to the reference current, the grid-connected inverter to output a current to the point of common coupling; and
   determining, when the voltage frequency exceeds a preset range, that an islanding effect occurs.

2. The islanding detection method according to claim 1, further comprising:
   determining, when the voltage frequency does not exceed the preset range, that the islanding effect does not occur.

3. The islanding detection method according to claim 1, wherein the determining, according to the frequency deviation, the voltage frequency, and the voltage phase, a reference current for injecting a frequency perturbation comprises:

   determining, according to a preset gain coefficient and the frequency deviation, a frequency perturbation amount;
   calculating, according to the voltage phase, the voltage frequency, and the frequency perturbation amount, a reference phase of the reference current; and
   determining, according to a preset current amplitude and the reference phase, the reference current.

4. The islanding detection method according to claim 1, further comprising:
determining, when switching from the preset closed-loop phase-locking manner to the preset open-loop phase-locking manner, a first phase that is latest detected in the preset closed-loop phase-locking manner as a phase initial value of the preset open-loop phase-locking manner.

5. The islanding detection method according to claim 1, further comprising:
determining, when switching from the preset open-loop phase-locking manner to the preset closed-loop phase-locking manner, a second phase that is latest detected in the preset open-loop phase-locking manner as a phase initial value of the preset closed-loop phase-locking manner.

6. The islanding detection method according to claim 1, wherein the controlling, according to the reference current, the grid-connected inverter to output a current to the point of common coupling comprises:

   obtaining a current output current of the grid-connected inverter;
   determining, according to the reference current, the current output current, and a preset inversion control algorithm, a drive signal; and
   controlling, by using the drive signal, the grid-connected inverter to output the current to the point of common coupling.

7. The islanding detection method according to claim 1, further comprising:
disconnecting, when determining that the islanding effect occurs, the grid-connected inverter from a grid.

8. An islanding detection apparatus, comprising:

   a voltage frequency detection module, configured to continuously detect a voltage frequency at a point of common coupling;
   a frequency deviation calculation module, configured to calculate, according to the voltage frequency, a frequency deviation of the voltage frequency between two adjacent detections;
   a voltage phase obtaining module, configured to detect, when the frequency deviation is less than a preset frequency threshold, a voltage phase in a preset closed-loop phase-locking manner, and detect, when the frequency deviation is greater than or equal to the preset frequency threshold, the voltage phase in a preset open-loop phase-locking manner;
   a reference current obtaining module, configured to determine, according to the frequency deviation, the voltage frequency, and the voltage phase, a reference current for injecting a frequency perturbation; and
   an islanding effect determining module, configured to control, according to the reference current, the grid-connected inverter to output a current to the point of common coupling, and determine, when the voltage frequency exceeds a preset range, that an islanding effect occurs.

9. A grid-connected inverter, comprising a controller and an inverter circuit, the controller being configured to perform the islanding detection method according to any one of claims 1 to 7.

10. A computer-readable storage medium, configured to store a computer program or code, the computer program or code, when executed by a processor, implementing the islanding detection method according to any one of claims 1 to 7.

FIG. 1

FIG. 2

S301
Continuously detect a voltage frequency at a point of common coupling

S302
Calculate, according to the voltage frequency, a frequency deviation of the voltage frequency between two adjacent detections

S303
Obtain, when the frequency deviation is less than a preset frequency threshold, a voltage phase in a preset closed-loop phase-locking manner

S304
Obtain, when the frequency deviation is greater than or equal to the preset frequency threshold, the voltage phase in a preset open-loop phase-locking manner

S305
Determine, according to the frequency deviation, the voltage frequency, and the voltage phase, a reference current for injecting a frequency perturbation

S306
Control, according to the reference current, the grid-connected inverter to output a current to the point of common coupling

S307
Determine, when the voltage frequency exceeds a preset range, that an islanding effect occurs

FIG. 3

400

Three-phase SRF-PLL

Vd

410    420    430

411    412    421    431

Va

Clark
transform
module

Vα

Park
transform
module

Vq

PI

Integrator

θ

Vb

Vc

Vβ

θ

θ

FIG. 4

S501

Continuously detect a voltage frequency at a point of common coupling

S502

Calculate, according to the voltage frequency, a frequency deviation of the voltage frequency between two adjacent detections

S503

Determine whether the frequency deviation is greater than or equal to a preset frequency threshold

No

Yes

S504

Obtain a voltage phase in a preset open-loop phase-locking manner

S505

Obtain the voltage phase in a preset closed-loop phase-locking manner

S506

Determine, according to the frequency deviation, the voltage frequency, and the voltage phase, a reference current for injecting a frequency perturbation

S507

Control, according to the reference current, the grid-connected inverter to output a current to the point of common coupling

S508

Whether the voltage frequency exceed a preset range

No

Yes

S509

Determine that an islanding effect occurs

S510

Determine that the islanding effect does not occur

FIG. 5

600

Islanding detection apparatus

610    620    630

631

Voltage frequency detection module

Frequency deviation calculation module

Closed-loop phase-locking module

632

Open-loop phase-locking module

640    650

Reference current obtaining module

Islanding effect determining module

FIG. 6

110

Grid-connected inverter

111

Controller

112

Inverter circuit

FIG. 7

## INTERNATIONAL SEARCH REPORT

| International application No. |
|---|
| **PCT/CN2024/093843** |

### A. CLASSIFICATION OF SUBJECT MATTER

G01R31/00(2006.01)i; G01R23/02(2006.01)i; G01R25/00(2006.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS; CNTXT; DWPI; WPABS; USTXT; EPTXT; WOTXT; CNKI: 深圳市正浩创新科技, 胡雄, 赵密, 陈熙, 王雷, 孤岛, 开环, 闭环, 锁相, 过零, 频率, 扰动, 电压, 电流, island, open loop, closed loop, phase lock+, zero crossing, frequency, inject +, voltage, current

### C. DOCUMENTS CONSIDERED TO BE RELEVANT

| Category* | Citation of document, with indication, where appropriate, of the relevant passages | Relevant to claim No. |
|---|---|---|
| PX | CN 116626418 A (ECOFLOW INC.) 22 August 2023 (2023-08-22) <br> claims 1-10 | 1-10 |
| A | CN 110247433 A (JIAOZUO POWER SUPPLY COMPANY OF STATE GRID HENAN ELECTRIC POWER COMPANY et al.) 17 September 2019 (2019-09-17) <br> see description, paragraphs [0004]-[0020] and [0038]-[0050], and figures 1-15 | 1-10 |
| A | CN 112782501 A (HEFEI UNIVERSITY OF TECHNOLOGY) 11 May 2021 (2021-05-11) <br> entire document | 1-10 |
| A | CN 114825367 A (NR ELECTRIC CO., LTD. et al.) 29 July 2022 (2022-07-29) <br> entire document | 1-10 |
| A | WO 2022156681 A1 (NR ELECTRIC CO., LTD. et al.) 28 July 2022 (2022-07-28) <br> entire document | 1-10 |
| A | US 2006146582 A1 (LIN BAOQUAN et al.) 06 July 2006 (2006-07-06) <br> entire document | 1-10 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 August 2024** | **14 August 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2024/093843** |

| Patent document cited in search report | | | Publication date (day/month/year) | Patent family member(s) | | | Publication date (day/month/year) |
| --- | --- | --- | --- | --- | --- | --- | --- |
| CN | 116626418 | A | 22 August 2023 | None | | | |
| CN | 110247433 | A | 17 September 2019 | None | | | |
| CN | 112782501 | A | 11 May 2021 | None | | | |
| CN | 114825367 | A | 29 July 2022 | None | | | |
| WO | 2022156681 | A1 | 28 July 2022 | None | | | |
| US | 2006146582 | A1 | 06 July 2006 | US | 7466570 | B2 | 16 December 2008 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310568828